# EUROPEAN PATENT SPECIFICATION

(11) **EP 0 545 488 B1**
(45) Date of publication and mention of the grant of the patent: **11.09.1996**
(21) Application number: 92203677.7
(22) Date of filing: 27.11.1992
(51) Int. Cl.: H01L 27/02

(54) **Semiconductor device comprising at least one power transistor and at least one control circuit with dynamic insulation circuit integrated monolithically in the same chip**
Halbleiteranordnung bestehend aus mindestens einem Leistungstransistor und zu mindest einer Steuerschaltung die auf demselben Chip zusammen mit einer dynamischen Isolierschaltung monolitisch integriert ist
Dispositif semi-conducteur comportant au moins un transistor ou puissance et au moins un circuit de commande intégré monolithiquement dans la même puce avec un circuit d'isolation dynamique

(30) Priority: 05.12.1991 IT MI913265
(43) Date of publication of application: 09.06.1993
(73) Proprietor: SGS-THOMSON MICROELECTRONICS S.r.l., I-20041 Agrate Brianza (Milano) (IT); CONSORZIO PER LA RICERCA SULLA MICROELETTRONICA NEL MEZZOGIORNO, I-95121 Catania (IT)
(72) Inventor: Paparo, Mario, San Giovanni La Punta CT (IT); Zambrano, Raffaele, San Giovanni La Punta CT (IT)
(74) Representative: Arena, Giovanni

(56) References cited:
- EP-A- 0 432 058
- US-A- 5 051 612

## Description

The present invention relates to a semiconductor electronic device with dynamic insulation circuit comprising at least one power transistor and at least one control circuit integrated monolithically in the same chip.

In the chip in which are provided semiconductor electronic devices of the above type there is normally provided an insulation region designed to ensure electric insulation of the individual components and therefore correct operation of the device.

So that said insulation region fulfils this function it is necessary that both junctions of the parasite vertical transistor which said region originates be normally reverse polarized. This is achieved by connecting the insulation region to a potential not greater than the minimum voltage applied to the device.

Therefore, since the terminal with potential lower than the supply battery is normally grounded, the insulation region is also grounded for the above reasons.

However, this provision is not effective in most cases. Indeed, it can happen for example that with switching on the load or spurious pulses on the supplies the voltage (Vout) of the collector (Cp) of the power transistor displays transiently negative values and thus gives rise to so-called 'subground' situations.

To avoid in these cases the parasite vertical transistor going into conduction there has been conceived a dynamic insulation circuit see EP-A-0 432 058 which calls for keeping the connection of the insulation region grounded when the Vout is positive and switching the grounding into a connection to the power transistor collector when the Vout displays subground transients.

However, said known dynamic insulation circuit does not allow for the fact that malfunctioning of the insulation region due to going into conduction of said parasite vertical transistor can occur even when negative voltage transients are applied to the control circuit.

The present invention allows achievement of at least the following advantages:
- provision of a semiconductor electronic device with dynamic insulation circuit ensuring insulation conditions even with negative voltage transients on the control circuit,
- reduction of implementation costs of the described dynamic insulation principle by means of integrated structures not requiring a polycrystalline silicon process,
- extension and optimization of the decisional circuitry part dedicated to piloting the synchronous switches which provide the dynamic insulation, and
- dynamic insulation of different insulation regions not connected together with variation of the voltage applied to the common substrate.

Semiconductor electronic devices with dynamic insulation circuit according to the present invention are defined in claim 1 and claim 2.

The characteritics of the present invention will be more clear by the following description and the annexed drawings of nonlimiting embodiment examples wherein:
- FIG.1: shows an example of a structure comprising a power transistor, a control transistor and an insulation region,
- FIG.2: shows an equivalent circuit of the structure of FIG. 1,
- FIG.3: shows the basic diagram of a known dynamic insulation circuit,
- FIG.4a: shows the basic diagram of the dynamic insulation circuit in accordance with the present invention,
- FIG.4b: shows the basic diagram of the dynamic insulation circuit in accordance with the present invention,
- FIG.5: shows the diagram of a realization circuit of the circuit CPI of FIG. 4,
- FIG.6: shows the basic diagram of the dynamic insulation in accordance with the present invention applied to a solid state 2-way switch,
- FIG.7: shows a first example of a realization structure of the switches S1 and S2 of FIGS. 4a and 4b,
- FIGS.8: to 11 shows phases of a realization process of the structure of FIG. 7,
- FIG.12: shows a second example of a realization structure of the switches S1 and S2 of FIGS. 4a and 4b,
- FIG.13: shows a third example of a realization structure of the switches S1 and S2 of FIG. 4, and
- FIG.14: shows an example of a realization structure of some components of the circuit of FIG. 6.

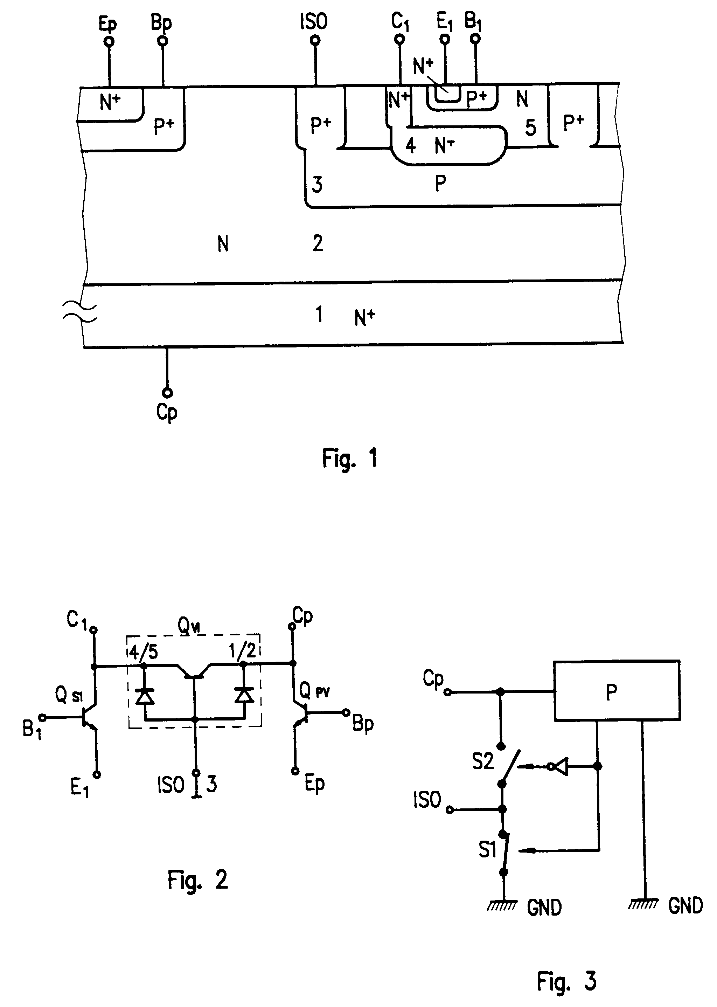

FIG.1 shows an example of a structure of a semiconductor electronic device comprising a power stage and a control circuit in which are represented for the sake of simplicity only one component of the integrated control circuit, a low voltage npn transistor with emitter, base and collector terminals indicated by E₁, B₁ and C₁ respectively and a single power transistor also of the npn type and having emitter, base and collector terminals indicated by Eₚ, Bₚ and Cₚ respectively and in which Eₚ together with the "-" terminal of the supply battery is designed to be grounded (directly or through one or more passive components inside or outside the monolithic circuit).

In said FIG.1 represents a substrate of N+ doped semiconductor material, 2 an N doped layer and 3 an insulation region with P doping designed to insulate the individual components of the control circuit from each other and from the power transistor once its ISO terminal is also grounded so as to ensure that both the junctions of the parasite transistor associated with the insulation region are always reverse polarized.

In FIG.2 is diagramed the equivalent electric circuit of the structure of FIG. 1. It shows the npn vertical parasite transistor (Qvi) which, normally polarized with both the junctions reversed, ensures insulation between the vertical power transistor (Qpv) and the signal transistor (Qs1) of the pilot circuit provided inside the layer 3.

FIG.3 illustrates the basic diagram of the dynamic insulation circuit in accordance with the known art (EP-A-0 432 058). Therein P represents a pilot circuit which detects the voltage level of the collector CP of the power transistor and holds the switch S1 (consisting of a vertical MOS transistor or a bipolar transistor) closed and the switch S2 (consisting of a lateral MOS transistor) open as long as said level is greater than the ground potential. As soon as said level falls transiently below said potential, P commands opening of S1 and simultaneously closing of the switch S2.

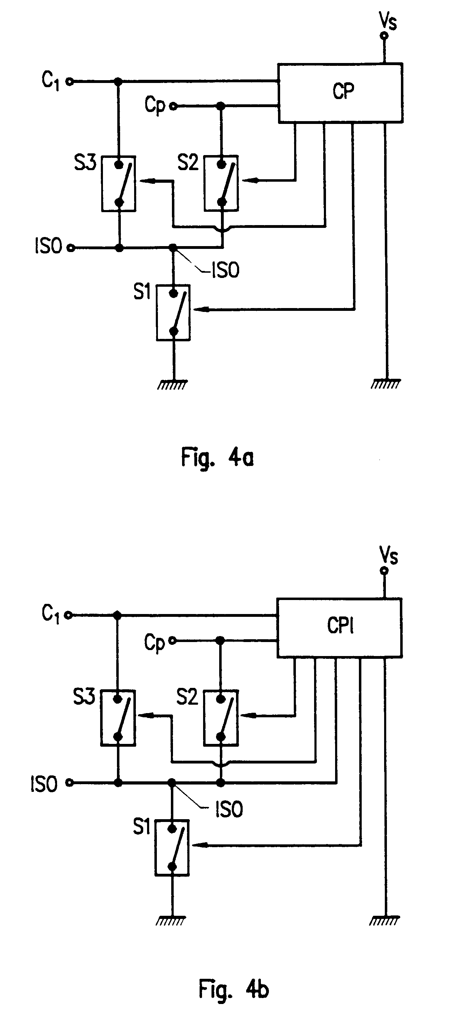

FIG.4a illustrates the basic diagram of the dynamic insulation circuit of the present invention. In accordance with said diagram the switch piloting circuit CPI detects, in addition to the voltage level of the collector C_{P} of the power transistor, the level of the collector C₁ of the control circuit. As long as the voltage of C_{P} and C₁ is greater than the voltage of the ground node, CPI holds the switch S1 closed and the switches S2 and S3 open. As soon as the potential of C_{P} or C₁ falls transiently below ground potential, CPI commands opening of S1 and closing of S2 or S3 respectively, i.e. it commands closing of the switch connected to the terminal from which arrives the most negative disturbance. If in the integrated circuit there exist other terminals subject to transient subground situations, the solution described above still applies by adding to S2 and S3 a number of switches equal to the number of the added terminals.

The circuit of FIG.4a, whose reference potential is ground, calls for separate supply Vs of the circuit CP designed to permit supply of CP even during subground transients. This separate supply, without interruptions, can be for example achieved simply by keeping uniformly charged a capacitance designed to supply power to CPI during the transients.

The circuit of FIG.4b in comparison with that of FIG. 4a calls for use as reference potential that of the ISO terminal instead of ground.

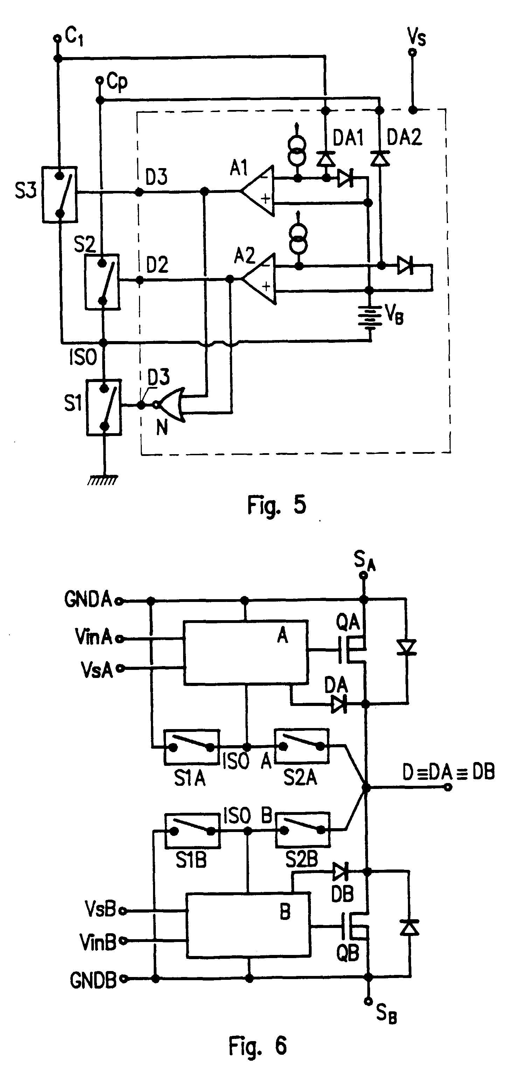

FIG.5 shows the diagram of an example of embodiment of the circuit CPI of FIG. 4a in which A1 and A2 represent two voltage comparators and N a NOR logic circuit. The voltage generator VB compensates for the voltage drop on the diodes DA1, DA2.

FIG.6 shows the basic diagram of the dynamic insulation in accordance with the present invention applied to a solid state 2-way switch (QA/QB) integrated in a single semiconductor material chip. In this diagram there are omitted for the sake of simplicity (in comparison with FIG. 5) the switches S3A and S3B for connection of the nodes ISO A and ISO B with the collector and drain terminals of the respective control circuits. The power switches QA and QB are piloted by appropriate circuits inserted also in the pilot circuits A and B respectively and designed to perform the above function.

In this case the two insulation regions of the control circuits of the power transistors QA and QB are not connected together because the elementary components contained in them must be free to follow the potential imposed on SA and SB by two external sources.

To withstand the voltages applied (on the order of several hundred volts) QA and QB must be vertical transistors and therefore their drain (or collector if QA and QB are provided by bipolar transistors and not MOS transistors as indicated in FIG. 6) coincide with the substrate of the semiconductor chip in which they are provided.

In a configuration of this type if a generator of alternating electromotive force is applied between the two terminals SA and SB leading to the surface of the chip, the substrate will be alternately subjected to reversal of polarity in relation to the local ground nodes.

Dynamic insulation in accordance with the invention will then provide that, on command of the pilot circuit A, the insulation ISO A of the control circuitry of the switch QA is alternately connected to the more negative local potential S_{A} or to the potential D if it is more negative than S_{A}. Similarly the insulation ISO B will always be taken upon command of the pilot circuit B to the lower of the potentials S_{B} and D regardless of what happens for ISO A (in the figures GNDA and GNDB represent ground nodes, VsA and VsB separate power supplies, and VinA and VinB optional control inputs to synchronize piloting of QA and QB by means of an external logic circuit not shown in the figures).

In implementing the dynamic insulation principle in accordance with the present invention it is advantageous to provide at least the switch S1 with a metal gate NMOS transistor and with the channel region achieved by means of selective etching of a thick oxide layer grown on the surface of the slice followed by a subsequent growth of the gate oxide. Further advantages are achieved by providing both the switches S1 and S2 with metal gate NMOS transistors of the 'double diffused' type, i.e in which both the source region and the channel region are the diffused type (with the channel region having a nonuniform dopant concentration profile along the surface).

This manner of implementation of the switches S1 and S2 is advantageous based on the following considerations:
- the NMOS transistors switch faster than the parasite bipolar transistor of the insulation structure and consequently a conduction of the latter transistor is not possible during switching,
- the channel length of a double diffused NMOS transistor is determined by the difference in the lateral diffusions of the source and body regions contrary to a transistor with uniform concentration channel region, for which the channel length is defined by a photolithographic process,
- the double diffused NMOS transistor is capable of withstanding high voltages.

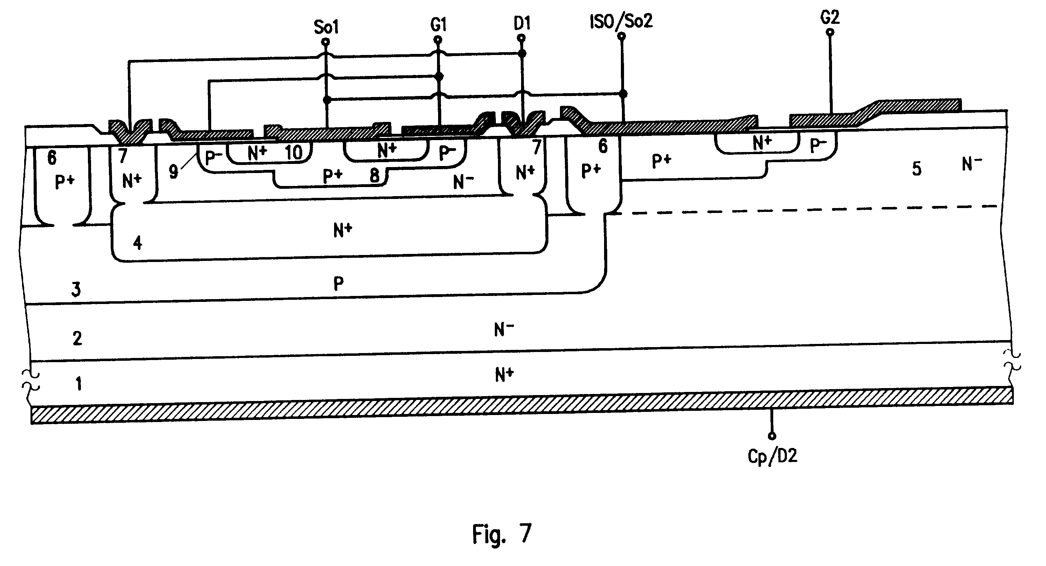

In FIG.7 is illustrated an example of a structure implementing the switches S1 and S2 of FIG. 4a and 4b with metal gate NMOS transistors of the 'double diffused' type and with channel region achieved beneath a thin oxide layer. In said figure So1, G1 and D1 represent the source, gate and drain terminals of the transistor implementing the switch S1 while So2, G2 and D2 represent the homologous terminals of the transistor implementing the switch S2.

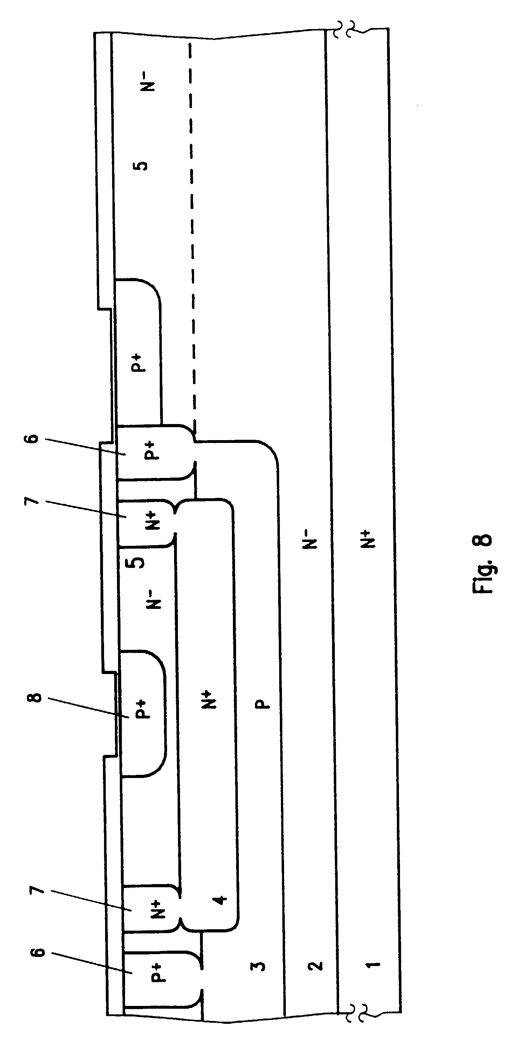

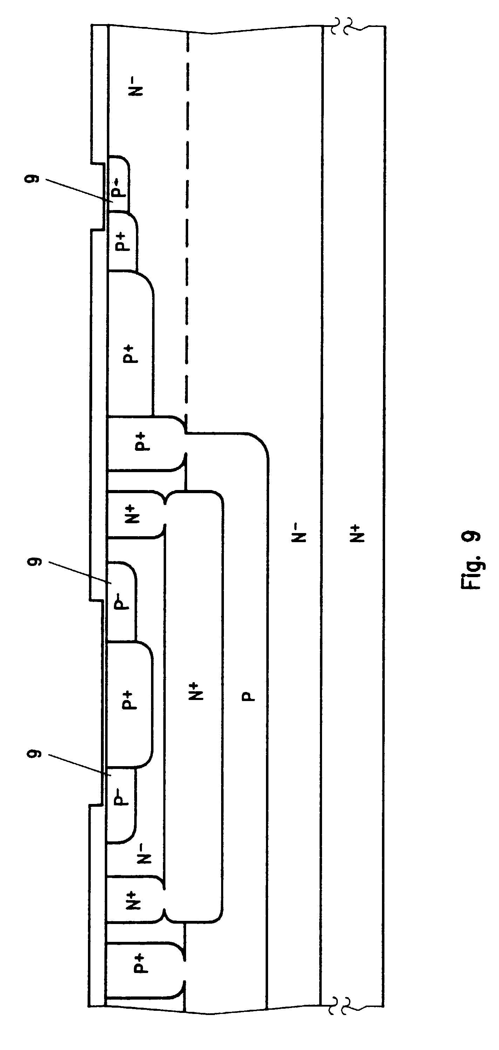

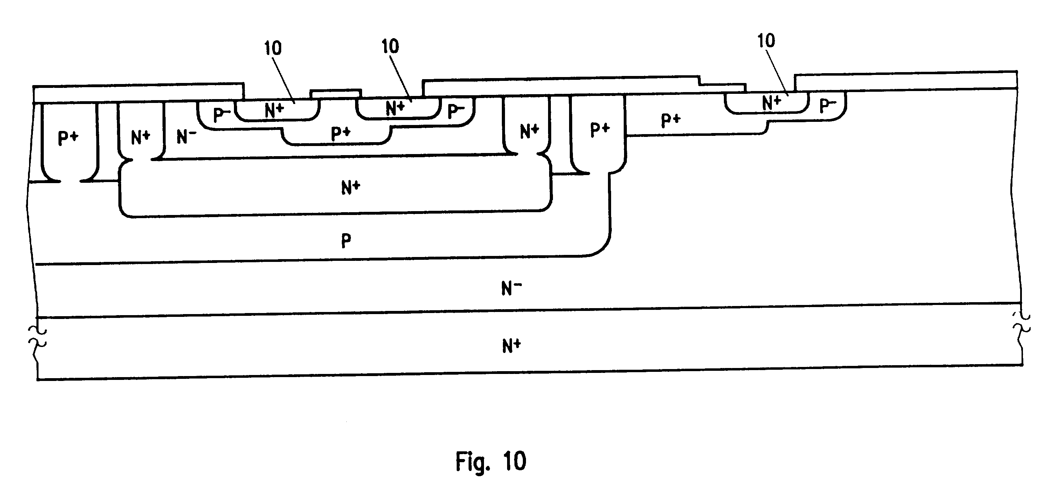

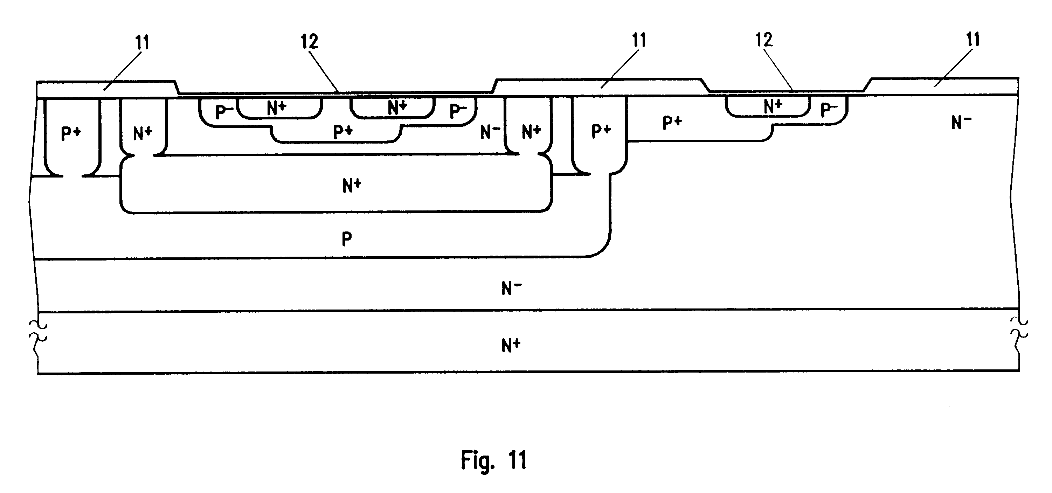

FIGS.8 to 11 illustrate the processing sequence which consists of the following phases:
1) growth of an n- epitaxial layer 2 on a monocrystalline substrate 1 of the same type of conductivity and low resistivity,
2) formation of the horizontal region 3 for insulation of the integrated control circuit (p-buried layer) of type p and of the collector region 4 with low resistivity of an npn transistor of the integrated control circuit (n-buried layer) of type n (this region acts as the low resistivity drain region of the NMOS transistor implementing S1),
3) growth of a second epitaxial layer 5 of type n-,
4) definition of the insulation regions 6 of type p+ and sink 7 of type n+ necessary for connecting to the surface of the device the horizontal insulation region and the low resistivity collector region respectively of an npn transistor of the integrated control circuit,
5) formation of the deep body region 8 of the NMOS transistor (which coincides with the base region of the npn transistor of the integrated control circuit),
6) formation of the body region 9 of the NMOS transistor (FIG. 9),
7) formation of the source region 10 of the NMOS transistor, coinciding with the emitter region of the npn transistor of the integrated control circuit (FIG. 10),
8) definition of the channel regions by selective etching of the thick oxide 11 and subsequently growth of the gate oxide 12 (FIG. 11),
9) opening of the contacts, provision of the metalization paths (with gate electrode function for the NMOS transistors in addition to interconnection of the device components) and finally metalization of the back thereof (FIG. 7).

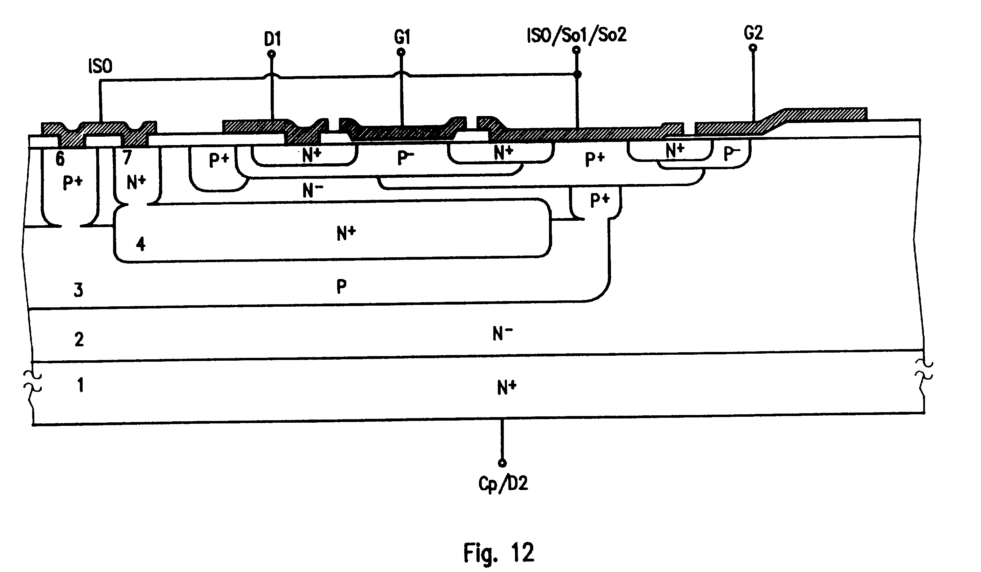

It is observed that, since only the switch S2 is subject to high voltages, the switch S1 can be provided (as exemplified in FIG.12) even by an NMOS transistor with uniform concentration channel region.

The process described above for the structure of FIG. 7 can be used in this case also, if there is provided a different layout for the deep body, body and source photomasking for the NMOS transistor implementing S1 (source and drain of the NMOS transistor are achieved using the same emitter diffusion of the npn transistor of the integrated control circuit and the buried type n layer is short-circuited with the channel region).

This variant of the structure in accordance with the present invention allows separate optimization of the channel regions of the two NMOS-FETs (it is possible for example to provide two different threshold voltages).

One possible shortcoming of the NMOS structures could be the Ron of the high voltage transistor (switch S2). Indeed, it is known that unipolar devices do not enjoy the phenomenon of conductivity modulation and therefore the voltage drop between source and drain of this transistor can be high.

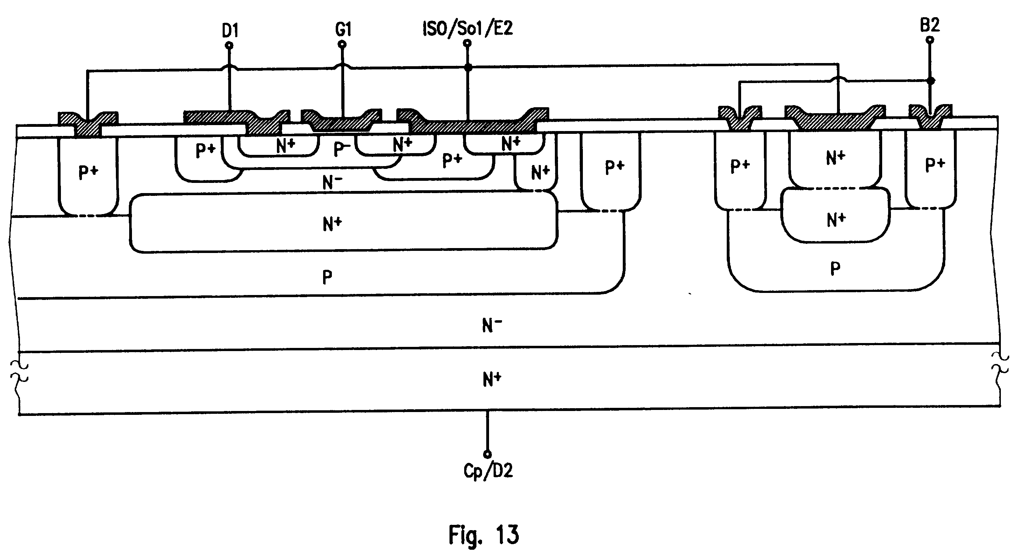

Under these conditions it is possible that, when the voltage Vout of the terminal CP is negative (and hence S2 is closed) between it and the insulation is established a potential differential greater than necessary for turning on the parasite bipolar transistor, which is equal to approximately 0.5V at 27°C. Turning on the parasite transistor is prevented by the present invention and in FIG.13 is shown implementation of the switch S2 (of the circuit of FIG. 5) with a bipolar transistor and implementation of S1 with a metal gate NMOS transistor with uniform concentration channel region.

The voltage applied to the insulation region differs from Vout (when Vout is negative) by one Vcesat, i.e. a quantity less than that necessary to turn on the parasite bipolar transistor associated with the insulation region.

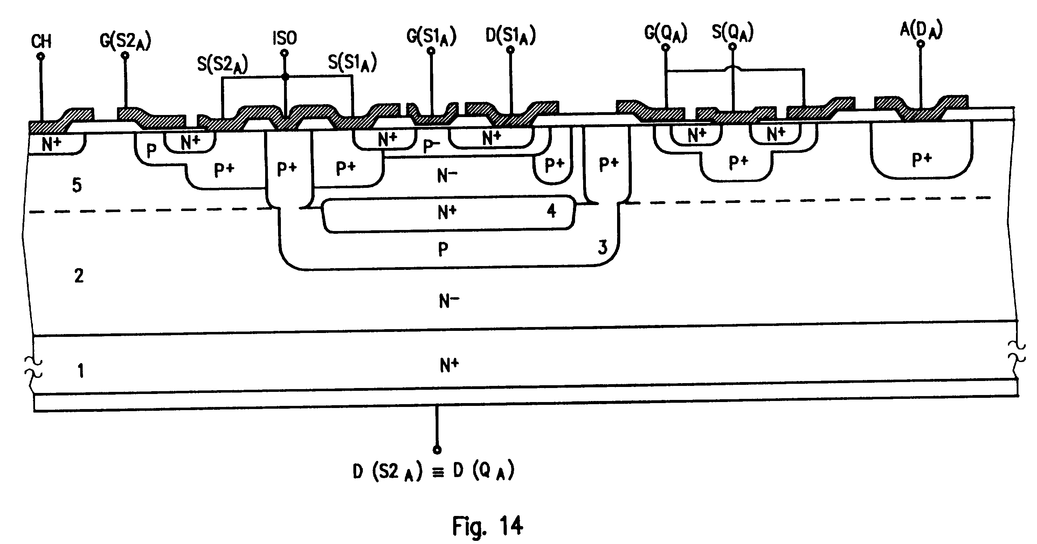

In FIG.14 is diagramed a possible structure providing, in accordance with the above criteria, some components of the circuit of FIG. 6 and in particular the switch pair S1_{A} and S2_{A} and the switch QA as well as the insulation region ISO_{A} (the structure of the corresponding components S1_{B}, S2_{B}, Q_{B} and the region ISOB is the same).

In the figures the meaning of the various symbols is as follows:
- CH:: channel stop region terminal
- A:: anode of DA
while the other abbreviations G( ), S(), D() represent the gate, source and drain respectively of the transistor implementing the switch indicated in parentheses.

The drain terminal D(S1_{A}) is grounded and the MOS transistor which provides the switch S1_{A} , which in a state of conduction has the source region more positive that the drain region, can in this manner support the negative transistors in a state of interdiction without the drain-body diode of said transistor going into conduction.

One variant affects the circuits of FIGS. 4a and 4b since the switch S3 and the circuit CP/CPI can be connected with another region of the control circuit transistor instead of with the collector C₁ of the control circuit transistor.

## Claims

1. Semiconductor electronic device with dynamic insulation circuit comprising at least one power transistor and at least one control circuit integrated monolithically in a same chip, wherein:
- the individual components of said control circuit are insulated from each other and from the power transistor by means of an insulation region,
- the insulation region is connected to a ground node by means of a first switch (S1),
- the insulation region is connected to the collector or drain (C_{P}) of the power transistor by means of a second switch (S2),
- a pilot circuit (CP) is connected to the collector or drain (C_{P}) of the power transistor, to the ground node and to said first and second switch, said pilot circuit being for commanding said first switch (S1) and said second switch (S2) such that the second switch is closed and the first switch is open when said collector or drain (C_{P}) has a potential lower than that of ground, and such that the second switch is open and the first switch is closed when said collector or drain (C_{P}) has a potential higher than that of ground,
characterized in that:
- the insulation region is connected to a region of a control circuit transistor by means of a third switch (S3),
- the pilot circuit is connected to said third switch (S3) and to said region of said control circuit transistor, said pilot circuit being for commanding said first switch (S1) and said third switch (S3) such that the third switch is closed and the first switch is open when said region has a potential lower than that of ground, and such that the third switch is open and the first switch is closed when said region has a potential higher than that of ground.

2. Semiconductor electronic device with dynamic insulation circuit comprising at least one power transistor and at least one control circuit integrated monolithically in a same chip, wherein:
- the individual components of said control circuit are insulated from each other and from the power transistor by means of an insulation region,
- the insulation region is connected to a ground node by means of a first switch (S1),
- the insulation region is connected to the collector or drain (C_{P}) of the power transistor by means of a second switch ( S2),
- a pilot circuit (CPI) is connected to the collector or drain (C_{P}) of the power transistor, to the ground node and to said first and second switch, said pilot circuit being for commanding said first switch (S1) and said second switch (S2) such that the second switch is closed and the first switch is open when said collector or drain (C_{P}) has a potential lower than that of the insulation region, and such that the second switch is open and the first switch is closed when said collector or drain (C_{P}) has a potential higher than that of the insulation region,
characterized in that:
- the insulation region is connected to a region of a control circuit transistor by means of a third switch (S3),
- the pilot circuit is connected to said third switch (S3), to said region of said control circuit transistor and to the insulation region, said pilot circuit being for commanding said first switch (S1) and said third switch (S3) such that the third switch is closed and the first switch is open when said region has a potential lower than that of the insulation region, and such that the third switch is open and the first switch is closed when said region has a potential higher than that of the insulation region.

3. Semiconductor electronic device with dynamic insulation circuit as set forth in claim 1 or 2 characterized in that said first switch (S1) is provided by a metal gate NMOS transistor with the channel region achieved beneath a thin layer (12) of oxide grown on the surface of the slice.

4. Semiconductor electronic device with dynamic insulation circuit as set forth in claim 3 characterized in that said NMOS transistor providing the first switch (S1) is the double diffused type.

5. Semiconductor electronic device with dynamic insulation circuit as set forth in claim 4 characterized in that said second switch (S2) is also provided by a metal gate NMOS transistor of the double diffused type with the channel region achieved under a thin layer (12) of oxide grown on the surface of the slice.

6. Semiconductor electronic device with dynamic insulation circuit as set forth in claim 4 characterized in that said first switch (S1) is provided by a metal gate NMOS transistor with uniform concentration channel region achieved under a thin layer (12) of oxide grown on the surface of the slice.

7. Semiconductor electronic device with dynamic insulation circuit as set forth in claim 3 characterized in that said NMOS transistor providing the first switch (S1) is the uniform concentration channel type and the second switch (S2) is provided by a bipolar transistor.

8. Semiconductor electronic device with dynamic insulation circuit as set forth in claim 3 characterized in that in said pilot circuit (CPI) are present in combination:
- a NOR logic circuit (N) whose output (D1) pilots said first switch (S1),
- a first and a second voltage comparator (A1,A2) whose inverting inputs (-) are connected with said region of said control circuit transistor and of said power transistor respectively, whose non inverting inputs (+) are connected with said ground or insulation node (ISO), and whose outputs pilot a third switch (S3) and a first input of said NOR circuit (N) and a second switch (S2) and a second input of said NOR circuit (N) respectively.

9. Semiconductor electronic device with dynamic insulation circuit as set forth in claim 3, present in the framework of a structure comprising two power switches (QA,QB) implemented by vertical transistors with source or emitter terminal (S_{A} ,S_{B}) in common with ground (GNDA,GNDB) of the respective pilot circuit, providing a 2-way switch and each equipped with a respective control circuit (A,B) with insulation regions not connected together, used to connect the terminal (ISO_{A} ,ISO_{B}) of the insulation region of each control circuit to said source or emitter terminal (S_{A},S_{B}) or to the collector or drain terminal (DA,DB) of the respective power switch (QA,QB) depending on whether the source or emitter terminal (S_{A},S_{B}) has potential less or greater than respectively said collector or drain terminal (DA,DB).

10. Semiconductor electronic device with dynamic insulation circuit as set forth in claim 9 characterized by the presence of two additional switches (S3A,S3B) capable of connecting the terminal of the insulation regions of each control circuit with the collector or drain terminal of a transistor of the respective control circuit if the latter is more negative than the common collector/drain (D) or the source or emitter terminals (S_{A},S_{B}).

## Patentansprüche

1. Elektronische Halbleiteranordnung mit dynamischer Isolierschaltung, die zumindest einen Leistungstransistor und zumindest eine Steuerschaltung umfaßt, die monolitisch in demselben Chip integriert sind, wobei:
- die einzelnen Komponenten der Steuerschaltung voneinander und von dem Leistungstransistor durch einen Isolierbereich isoliert sind,
- der Isolierbereich mit einem Erdungsknoten durch einen ersten Schalter (S1) verbunden ist,
- der Isolierbereich mit dem Kollektor oder Drain (C_{P}) des Leistungstransistors durch einen zweiten Schalter (S2) verbunden ist,
- eine Pilotschaltung (CP) mit dem Kollektor oder Drain (C_{P}) des Leistungstransistors, mit dem Erdungsknoten und mit dem ersten und zweiten Schalter verbunden ist, wobei die Pilotschaltung dazu dient, den ersten Schalter (S1) und den zweiten Schalter (S2) so zu steuern, daß der zweite Schalter geschlossen ist und der erste Schalter offen ist, wenn der Kollektor oder Drain (C_{P}) ein geringeres Potential als Erde hat, und daß der zweite Schalter offen ist und der erste Schalter geschlossen ist, wenn der Kollektor oder Drain (C_{P}) ein höheres Potential als Erde hat,
dadurch gekennzeichnet, daß:
- der Isolierbereich mit einem Bereich eines Steuerschaltungstransistors durch einen dritten Schalter (S3) verbunden ist,
- die Pilotschaltung mit dem dritten Schalter (S3) und mit dem Bereich des Steuerschaltungstransistors verbunden ist, wobei die Pilotschaltung dazu dient, den ersten Schalter (S1) und den dritten Schalter (S3) so zu steuern, daß der dritte Schalter geschlossen ist und der erste Schalter offen ist, wenn der Bereich ein geringeres Potential als Erde hat, und daß der dritte Schalter offen ist und der erste Schalter geschlossen ist, wenn der Bereich ein höheres Potential als Erde hat.

2. Elektronische Halbleiteranordnung mit dynamischer Isolierschaltung, die zumindest einen Leistungstransistor und zumindest eine Steuerschaltung umfaßt, die monolitisch in demselben Chip integriert sind, wobei:
- die einzelnen Komponenten der Steuerschaltung voneinander und von dem Leistungstransistor durch einen Isolierbereich isoliert sind,
- der Isolierbereich mit einem Erdungsknoten durch einen ersten Schalter (S1) verbunden ist,
- der Isolierbereich mit dem Kollektor oder Drain (C_{P}) des Leistungstransistors durch einen zweiten Schalter (S2) verbunden ist,
- eine Pilotschaltung (CPI) mit dem Kollektor oder Drain (C_{P}) des Leistungstransistors, mit dem Erdungsknoten und mit dem ersten und zweiten Schalter verbunden ist, wobei die Pilotschaltung dazu dient, den ersten Schalter (S1) und den zweiten Schalter (S2) so zu steuern, daß der zweite Schalter geschlossen ist und der erste Schalter offen ist, wenn der Kollektor oder Drain (C_{P}) ein geringeres Potential hat als das des Isolierbereichs, und daß der zweite Schalter offen ist und der erste Schalter geschlossen ist, wenn der Kollektor oder Drain (C_{P}) ein höheres Potential hat als das des Isolierbereichs,
dadurch gekennzeichnet, daß :
- der Isolierbereich mit einem Bereich eines Steuerschaltungstransistors durch einen dritten Schalter (S3) verbunden ist,
- die Pilotschaltung mit dem dritten Schalter (S3), mit dem Bereich des Steuerschaltungsstransistors und mit dem Isolierbereich verbunden ist, wobei die Pilotschaltung dazu dient, den ersten Schalter (S1) und den dritten Schalter (S3) so zu steuern, daß der dritte Schalter geschlossen ist und der erste Schalter offen ist, wenn der Bereich ein geringeres Potential hat als das des Isolierbereichs, und daß der dritte Schalter offen ist und der erste Schalter geschlossen ist, wenn der Bereich ein höheres Potential hat als das des Isolierbereichs.

3. Elektronische Halbleiteranordnung mit dynamischer Isolierschaltung gemäß Anspruch 1 oder 2, dadurch gekennzeichnet, daß der erste Schalter (S1) durch einen Metall-Gate-NMOS-Transistor gebildet wird, wobei der Kanalbereich neben einer dünnen Schicht (12) aus Oxyd ausgeführt ist, das auf der Oberfläche der Scheibe gewachsen ist.

4. Elektronische Halbleiteranordnung mit dynamischer Isolierschaltung gemäß Anspruch 3, dadurch gekennzeichnet, daß der den ersten Schalter (S1) bildende NMOS-Transistor ein Doppeldiffusionstransistor ist.

5. Elektronische Halbleiteranordnung mit dynamischer Isolierschaltung gemäß Anspruch 4, dadurch gekennzeichnet, daß der zweite Schalter (S2) ebenfalls durch einen Metall-Gate-NMOS-Transistor vom Doppeldiffusionstyp gebildet wird, wobei der Kanalbereich unter einer dünner Schicht (12) aus Oxyd ausgeführt ist, das auf der Oberfläche der Scheibe gewachsen ist.

6. Elektronische Halbleiteranordnung mit dynamischer Isolierschaltung gemäß Anspruch 4, dadurch gekennzeichnet, daß der erste Schalter (S1) durch einen Metall-Gate-NMOS-Transistor gebildet wird mit einem Kanalbereich gleichförmiger Konzentration, der unter einer dünnen Schicht (12) aus Oxyd ausgeführt ist, das auf der Oberfläche der Scheibe gewachsen ist.

7. Elektronische Halbleiteranordnung mit dynamischer Isolierschaltung gemäß Anspruch 3, dadurch gekennzeichnet, daß der den ersten Schalter (S1) bildende NMOS-Transistor ein Typ mit einem Kanal mit gleichförmiger Konzentration ist, und der zweite Schalter (S2) durch einen bipolaren Transistor gebildet wird.

8. Elektronische Halbleiteranordnung mit dynamischer Isolierschaltung gemäß Anspruch 3, dadurch gekennzeichnet, daß in der Pilotschaltung (CPI) in Kombination vorhanden sind:
- eine NOR-Logikschaltung (N), deren Ausgang (D1) den ersten Schalter (S1) steuert,
- einen ersten und einen zweiten Spannungsvergleicher (A1, A2), deren invertierende Eingänge (-) mit dem Bereich des Steuerschaltungstransistors bzw. des Leistungstransistors verbunden sind, deren nicht invertierende Eingänge (+) mit dem Erdungs- oder Isolierknoten (ISO) verbunden sind, und deren Ausgänge jeweils einen dritten Schalter (S3) und einen ersten Eingang der NOR-Schaltung (N) und einen zweiten Schalter (S2) und einen zweiten Eingang der NOR-Schaltung (N) steuern.

9. Elektronische Halbleiteranordnung mit dynamischer Isolierschaltung gemäß Anspruch 3, die im Rahmen einer Struktur vorliegt, die zwei Leistungsschalter (QA, QB) umfaßt, die durch Vertikaltransistoren, deren Source-oder Emitteranschluß (S_{A}, S_{B}) gemeinsam mit der Erde (GNDA, GNDB) der jeweiligen Pilotschaltung verbunden sind, verwirklicht sind, die einen in beiden Richtungen leitfähigen Schalter bilden und von denen jeder mit einer jeweiligen Steuerschaltung (A,B) mit nicht miteinander verbundenen Isolierbereichen ausgestattet ist, die dazu verwendet werden, den Anschluß (ISO_{A}, ISO_{B}) des Isolierbereichs jeder Steuerschaltung mit dem Source-oder Emitteranschluß (S_{A}, S_{B}) oder mit dem Kollektor-oder Drainanschluß (DA, DB) des jeweiligen Leistungsschalters (QA, QB) zu verbinden, in Abhängigkeit davon, ob der Source- oder Emitteranschluß (S_{A},S_{B}) ein geringeres oder ein größeres Potential hat als jeweils der Kollektor- oder Drainanschluß (DA, DB).

10. Elektronische Halbleiteranordnung mit dynamischer Isolierschaltung gemäß Anspruch 9, gekennzeichnet durch das Vorhandensein zweier zusätzlicher Schalter (S3A, S3B), die in der Lage sind, den Anschluß der Isolierbereiche jeder Steuerschaltung mit dem Kollektor-oder Drainanschluß eines Transistors der jeweiligen Steuerschaltung zu verbinden, wenn der letztere negativer ist als der gemeinsame Kollektor/Drain- (D) oder die Source- oder Emitteranschlüsse (S_{A}, S_{B}).

## Revendications

1. Dispositif électronique à semiconducteur muni d'un circuit d'isolement dynamique comprenant au moins un transistor de puissance et au moins un circuit de commande intégré de façon monolithique dans une même puce, dans lequel :
les composants individuels du circuit de commande sont isolés les uns des autres et du transistor de puissance par une région d'isolement,
la région d'isolement est reliée à un noeud de masse par un premier commutateur (S1),
la région d'isolement est connectée au collecteur ou au drain (C_{P}) du transistor de puissance par un second commutateur (S2),
un circuit pilote (CP) est connecté au collecteur ou au drain (C_{P}) du transistor de puissance, au noeud de masse et aux premier et second commutateurs, le circuit pilote étant destiné à commander les premier (S1) et second (S2) commutateurs de sorte que le second commutateur est fermé et le premier est ouvert quand le collecteur ou le drain (C_{P}) a un potentiel inférieur à celui de la masse, et de sorte que le second commutateur est ouvert et le premier est fermé quand le collecteur ou le drain (C_{P}) a un potentiel supérieur à celui de la masse,
caractérisé en ce que :
la région d'isolement est connectée à une région d'un transistor du circuit de commande par un troisième commutateur (S3),
le circuit pilote est connecté au troisième commutateur (S3) et à ladite région du transistor du circuit de commande, le circuit pilote étant destiné à commander les premier (S1) et troisième (S3) commutateurs de sorte que le troisième commutateur est fermé et le premier est ouvert quand ladite région est à un potentiel inférieur à celui de la masse, et que le troisième commutateur est ouvert et le premier est fermé quand ladite région est à un potentiel supérieur à celui de la masse.

2. Dispositif électronique à semiconducteur muni d'un circuit d'isolement dynamique comprenant au moins un transistor de puissance et au moins un circuit de commande intégré de façon monolithique dans une même puce, dans lequel :
les composants individuels du circuit de commande sont isolés les uns des autres et du transistor de puissance par une région d'isolement,
la région d'isolement est reliée à un noeud de masse par un premier commutateur (S1),
la région d'isolement est connectée au collecteur ou au drain (C_{P}) du transistor de puissance par un second commutateur (S2),
un circuit pilote (CPI) est connecté au collecteur ou au drain (C_{P}) du transistor de puissance, au noeud de masse et aux premier et second commutateurs, le circuit pilote étant destiné à commander les premier (S1) et second (S2) commutateurs de sorte que le second commutateur est fermé et le premier est ouvert quand le collecteur ou le drain (C_{P}) a un potentiel inférieur à celui de la région d'isolement, et que le second commutateur est ouvert et le premier est fermé quand le collecteur ou le drain (C_{P}) a un potentiel supérieur à celui de la région d'isolement,
caractérisé en ce que :
la région d'isolement est connectée à une région d'un transistor du circuit de commande par un troisième commutateur (S3),
le circuit pilote est connecté au troisième commutateur (S3), à ladite région du transistor du circuit de commande et à la région d'isolement, le circuit pilote étant destiné à commander les premier (S1) et troisième (S3) commutateurs de sorte que le troisième commutateur est fermé et le premier est ouvert quand ladite région est à un potentiel inférieur à celui de la région d'isolement, et que le troisième commutateur est ouvert et le premier est fermé quand ladite région est à un potentiel supérieur à celui de la région d'isolement.

3. Dispositif électronique à semiconducteur muni d'un circuit d'isolement dynamique selon la revendication 1 ou 2, caractérisé en ce que le premier commutateur (S1) est constitué d'un transistor NMOS à grille métallique, la région de canal étant réalisée sous une couche mince (12) d'oxyde amenée à croître sur la surface de la tranche.

4. Dispositif électronique à semiconducteur muni d'un circuit d'isolement dynamique selon la revendication 3, caractérisé en ce que le transistor NMOS constituant le premier commutateur (S1) est du type double diffusé.

5. Dispositif électronique à semiconducteur muni d'un circuit d'isolement dynamique selon la revendication 4, caractérisé en ce que le second commutateur (S2) est également constitué d'un transistor NMOS à grille métallique du type double diffusé, la région de canal étant réalisée sous une couche mince (12) d'oxyde amenée à croître sur la surface de la tranche.

6. Dispositif électronique à semiconducteur muni d'un circuit d'isolement dynamique selon la revendication 4, caractérisé en ce que le premier commutateur (S1) est constitué d'un transistor NMOS à grille métallique, une région de canal à concentration uniforme étant réalisée sous une couche mince (12) d'oxyde amenée à croître sur la surface de la tranche.

7. Dispositif électronique à semiconducteur muni d'un circuit d'isolement dynamique selon la revendication 3, caractérisé en ce que le transistor NMOS constituant le premier commutateur (S1) est du type à canal à concentration uniforme et le second commutateur (S2) est constitué d'un transistor bipolaire.

8. Dispositif électronique à semiconducteur muni d'un circuit d'isolement dynamique selon la revendication 3, caractérisé en ce que le circuit pilote (CPI) comporte en combinaison :
un circuit logique NON OU (N) dont la sortie (D1) pilote le premier commutateur (S1),
des premier et second comparateurs de tension (A1, A2) dont les entrées inverseuses (-) sont connectées à ladite région du transistor du circuit de commande et du transistor de puissance, respectivement, dont les entrées non-inverseuses (+) sont connectées à la masse ou au noeud d'isolement (ISO) et dont les sorties pilotent un troisième commutateur (S3) et une première entrée du circuit NON OU (N) et un second commutateur (S2) et une seconde entrée du circuit NON OU (N), respectivement.

9. Dispositif électronique à semiconducteur muni d'un circuit d'isolement dynamique selon la revendication 3, présent dans une structure comprenant deux commutateurs de puissance (QA, QB) réalisés sous forme de transistors verticaux ayant une borne de source ou d'émetteur (S_{A}, S_{B}) en commun avec la masse (GNDA, GNDB) du circuit pilote respectif, fournissant un commutateur bidirectionnel et dont chacun est équipé d'un circuit de commande respectif (A/D) avec des régions d'isolement non-connectées l'une à l'autre, utilisés pour connecter la borne (ISOA, ISOB) de la région d'isolement de chaque circuit de commande à la borne de source ou d'émetteur (S_{A}, S_{B}) ou à la borne de collecteur ou de drain (DA, DB) du commutateur de puissance respectif (QA, QB) selon que la borne de source ou d'émetteur (S_{A}, S_{B}) a un potentiel inférieur ou supérieur, respectivement, à la borne de collecteur ou de drain (DA, DB).

10. Dispositif électronique à semiconducteur muni d'un circuit d'isolement dynamique selon la revendication 9, caractérisé par la présence de deux commutateurs supplémentaires (S3A, S3B) capables de connecter la borne des régions d'isolement de chaque circuit de commande à la borne de collecteur ou de drain d'un transistor du circuit de commande respectif si ce dernier est plus négatif que les bornes de collecteur/drain (D) ou de source/émetteur (S_{A}, S_{B}).
